Europäisches Patentamt

European Patent Office

Office européen des brevets

(19)

(11) Numéro de publication: **0 389 342**

**A1**

(12) **DEMANDE DE BREVET EUROPEEN**

(21) Numéro de dépôt: **90400714.3**

(22) Date de dépôt: **16.03.90**

(51) Int. Cl.5: **H01J 37/141, H01J 3/22**

(30) Priorité: **21.03.89 FR 8903674**

(43) Date de publication de la demande:
**26.09.90 Bulletin 90/39**

(84) Etats contractants désignés:
**DE FR GB**

(71) Demandeur: **CAMECA**
**103, Boulevard Saint-Denis**
**F-92400 Courbevoie(FR)**

(72) Inventeur: **Rouberol, Jean-Michel**
**THOMSON-CSF SCPI Cédex 67**
**F-92045 Paris la Défense(FR)**
Inventeur: **Tong, Mathias**
**THOMSON-CSF SCPI Cédex 67**
**F-92045 Paris la Défense(FR)**

(74) Mandataire: **Lincot, Georges et al**
**THOMSON-CSF SCPI**
**F-92045 PARIS LA DEFENSE CEDEX 67(FR)**

(54) **Lentille électromagnétique composite à focale variable.**

(57) La lentille est formée par l'association de deux lentilles électromagnétiques partageant un même circuit magnétique (4). La première lentille est traversée par un canal central (10) et comporte l'une de ses extrémités un entrefer annulaire (8) qui coupe le canal central suivant une direction de plan perpendiculaire à l'axe optique (1).

La deuxième lentille entoure l'entrefer annulaire 8 de la première lentille, elle comporte un entrefer annulaire (15) délimité par deux lèvres dont les parois sont de révolution autour de l'axe optique (1) et dont les bords (5b, 14) ont la forme de deux surfaces planes situées dans un même plan perpendiculaire à l'axe optique (1). Des bobines d'induction (2 et 3) permettent de faire varier le flux magnétique des entrefers (8) et (15).

Application : microscope électronique à balayage et de test, sonde électronique.

FIG.1

## Lentille électromagnétique composite à focale variable

La présente invention conçerne une lentille électromagnétique composite à focale variable permettant une variation importante de sa distance focale, sans déplacer l'objet ni l'image ; notamment ce dernier qui détermine la distance séparant la lentille de l'objet à observer, cette distance étant encore désignée par l'abréviation WD de "Working distance" dans le langage anglo-saxon.

Elle s'applique aux réalisations de microscopes électroniques à balayage et/ou à celles d'appareils dérivés des microscopes à balayage, testeurs de circuits intégrés par faisceaux d'électrons ou microsondes électroniques, dans lesquelles la concentration du faisceau d'électrons primaires sur des objets à tester ou à sonder est obtenue grâce à une lentille électromagnétique, notamment celle qualifiée par "objectif focalisant le faiseau" ; car, les caractéristiques optiques de focalisation et les sensibilités des détecteurs (d'électrons) placés au voisinage de cette lentille dépendent considérablement du champ magnétique B(Z) axial produit par cette lentille.

Dans ces applications les émissions des électrons secondaires causées par l'impact des faisceaux d'électrons primaires sur les objets à tester sont mesurés au moyen de détecteurs placés, soit en dessous de la lentille de focalisation formant l'objectif de l'appareil, et au dessus des objets ou échantillons à tester, soit au dessus de l'objectif, les électrons secondaires émis par les objets ou les échantillons étant dirigés au travers d'un canal central de la lentille de focalisation formant l'objectif.

Cependant comme la sensibilité de détection des électrons secondaires dépend dans chaque application de la distribution du champ magnétique au dessus des objets ou des échantillons à tester, chaque lentille de focalisation, spécifique d'une application, est généralement inapte à fonctionner pour d'autres applications, sauf avoir à modifier de façon importante le dispositif de focalisation ou l'agencement des dispositifs de détection des électrons secondaires, que ceux-ci soient des types connus sous les désignations anglo-saxonnes "Everhart-Thornlay" ou "In Lens".

Ainsi pour obtenir une forte réduction des aberrations optiques dans un microscope électronique, il est connu de placer l'objet à tester dans la zone à fort champ de la lentille de focalisation, en plaçant soit l'objet à tester dans l'entrefer de la lentille, soit en plaçant l'objet à tester devant une autre lentille semi-blindée unipolaire dont le plan principal image est placé entre la face avant de la lentille et l'objet à tester. Mais l'une ou l'autre des solutions précédentes ne convient plus pour réaliser, par exemple, des testeurs de circuits intégrés car elles ne permettent pas d'obtenir au niveau des objets à tester un champ d'induction très inférieur à celui qui règne dans l'entrefer de la lentille.

Le but de l'invention est de pallier les inconvénients précités.

A cet effet, l'invention a pour objet une lentille électromagnétique composite à focale variable, caractérisé en ce qu'elle comprend une première lentille blindée accolée à une deuxième lentille unipolaire, les deux lentilles étant traversées par un même canal central s'étendant autour d'un axe optique commun aux deux lentilles pour permettre le passage de particules électrisées à destination ou en provenance d'un objet ou échantillon à observer au travers de la première et de la deuxième lentille, chaque lentille étant munie d'une bobine d'induction pour déplacer la position sur l'axe optique de la lentille composite résultante en fonction du courant d'excitation des bobines d'induction des première et deuxième lentilles.

L'invention a pour principal avantage qu'elle permet, en intégrant deux lentilles dans un seul bloc magnétique, d'obte nir un objectif à focale variable pouvant être utilisé aussi bien dans des microscopes électroniques à balayage, des microsondes électroniques à haute résolution ou encore dans des testeurs de circuits intégrés. Elle permet également le test d'échantillons de grande dimension et la modification des caractéristiques électro-optiques des appareils sans nécessiter pour autant des réglages mécaniques comme celui par exemple de la distance de l'objectif au dessus des objets ou échantillons à tester.

D'autres caractéristiques et avantages de l'invention apparaîtront ci-après à l'aide de la description faite en regard des dessins annexés qui représentent :

- la figure 1 une vue en coupe d'un mode de réalisation d'une lentille à focale variable selon l'invention ;

- les figures 2, 3 et 4 des graphes représentant les densités de flux magnétique en fonction du courant d'excitation traversant les bobines d'induction de la lentille représentée à la figure 1 ;

- la figure 5 un schéma optique représentant une focalisation d'électrons primaires sur un échantillon au travers d'une lentille ;

- les figures 6a et 6b deux schémas simplifiés représentant deux positions possibles d'un détecteur par rapport au plan principal de la lentille à focale variable selon l'invention ;

- la figure 7 la latitude de réglage du plan principal de la lentille à facale variable selon l'invention.

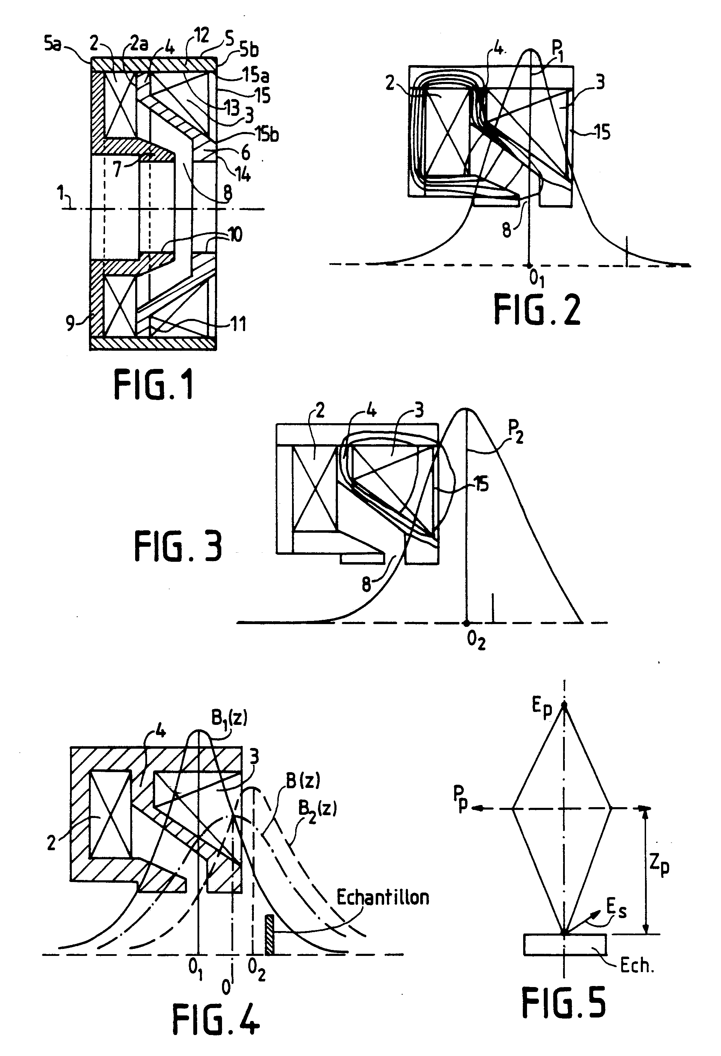

La lentille électromagnétique à focale variable qui est représentée à la figure 1, est formée par l'assemblage autour d'un même axe optique 1, de deux lentilles électromagnétiques respectivement blindée et unipolaire accolées, excitées par deux bobines d'induction 2 et 3 montées sur un circuit magnétique 4 commun aux deux lentilles. La première lentille blindée à une forme similaire à celle de la lentille finale équipant généralement les microscopes électroniques à balayage. Elle comporte à l'intérieur d'un corps 5 de révolution autour de l'axe optique 1, cylindrique de préférence, une pièce polaire avant 6 séparée d'une pièce polaire cylindrique 7 par un entrefer annulaire disposé suivant une direction de plan perpendiculaire à l'axe optique 1. La pièce polaire 7 supporte la bobine d'excitation 2. Elle comporte une embase circulaire 9 fermant une première extrémité 5a du corps cylindrique 5, pour permettre d'une part le logement de la bobine d'induction 2 dans l'espace délimité par le corps cylindrique 5, la pièce polaire avant 6 et l'embase 9, ainsi que d'autre part, la circulation du flux magnétique induit par la bobine 2 dans le circuit magnétique formé par la pièce polaire avant 6, le corps cylindrique 5, l'entrefer 8 et l'embase 9. La pièce polaire avant 6 et la pièce polaire cylindrique 7 sont percées d'un trou 10 formant le canal central de la lentille. Le trou 10 a son axe longitudinal confondu avec l'axe optique 1, pour permettre la circulation d'électrons ou éventuellement de toutes autres particules électrisées au travers de la lentille le long de l'axe optique 1. La pièce polaire avant 6 a la forme d'un tronc de cône et est munie d'une embase 11 reposant sur un flanc 2a de la bobine 2 pour permettre l'éloignement de la bobine 2 de l'entrefer annulaire 8 et l'engagement à l'intérieur de la pièce avant 6 de l'extrémité de la pièce polaire 7 opposée à l'embase 9 pour former l'entrefer annulaire 8.

La deuxième lentille unipolaire est formée par la bobine 3 et la partie du circuit magnétique 4 formée par la pièce polaire avant 6 et la partie avant 12 du corps cylindrique 5 qui entoure la pièce polaire avant 6. La bobine 3 est montée sur le tronc de cône de la pièce polaire avant 6 dans l'espace compris entre la pièce polaire avant 6 et la partie intérieure 13 du corps cylindrique 5, pour permettre au flux magnétique induit par la bobine 3 de circuler dans le circuit magnétique formé par, la pièce polaire avant 6 la partie avant 12 du corps cylindrique 5 et un entrefer annulaire 15. L'entrefer 15 est délimité par les deux lèvres formées par la partie avant 12 du corps cylindrique 5 et par la partie conique de tronc de cône 14. Les arêtes 15a et 15b de l'entrefer annulaire 15 sont si.tuées dans un plan perpendiculaire à l'axe optique 1, elles sont situées d'une part, à l'intersection de la deuxième extrémité 5b du cylindre 5 et de la partie intérieure 13 et d'autre part, à l'intersection de la petite base 14 du tronc de cône avec sa partie conique.

Pour la commodité de l'exposé, il est supposé dans ce qui suit que les deux lentilles qui forment la lentille composite de l'invention sont des lentilles minces, chacune d'elles se trouvant dans un plan perpendiculaire à l'axe optique à l'endroit où le champ magnétique qu'elle produit est maximal. Ainsi la première lentille est placée au voisinage du plan médian de l'entrefer 8 et passe par le point $O_1$ de la figure 2, elle reste a cette position indépendamment du courant d'excitation de la bobine 2.

Par contre la position $O_2$ de la deuxième lentille sur l'axe optique 1 est située comme le montre la figure 3 devant la pièce polaire avant 6 de la lentille à l'endroit où le flux fourni par l'entrefer 15 est maximum.

Lorsque les deux bobines 2 et 3 sont parcourues par des courants électriques, les flux circulant entre les deux entrefers 8 et 15 sont additifs. Il en résulte comme le montre les figures 4 et 5 que la répartition finale du champ magnétique axial $B(Z)$ est la combinaison linéaire des répartitions $B_1(Z)$ et $B_2(Z)$, induites respectivement par les bobines 2 et 3. En somme, c'est la courbe $B(z)$ ajustable qui conditionne la position du plan principal résultant : son centre $O$ peut être placé dans les limites $O_1$ et $O_2$ ; ainsi, sa distance $ZP$ par rapport à l'échantillon et la distance focale deviennent variables et ajustables dans de larges limites, même dans le cas d'un échantillon placé à la sortie de la lentille avec une distance de travail $DT$ constante.

D'après l'illustration de la figure 4, les conditions de cette composition additive des flux sont :
- La distance $O_1O_2$ est égale ou inférieure à la valeur moyenne des largeurs (à mi-hauteur) des courbes $B_1(Z)$ et $B_2(Z)$ ; ceci, telle que la courbe résultante $B(Z)$ de la composition linéaire ou additive n'ait pas de maximum secondaire (cause d'aberrations) ;
- La distance $O_1O_2$ reste assez importante pour que la position du sommet $O$ de la courbe $B(Z)$ puisse être ajustée avec une marge significative.

Enfin, les hauteurs des plans principaux (objet et image) définies par la courbe $B(Z)$ étant toutes très proches du sommet $O$, on peut donc appliquer l'approximation pour une lentille mince et considérer un plan principal résultant donnant la distance $ZP$ de la figure 5.

C'est cette possibilité de faire varier la distance $ZP$ qui permet aux appareils munis de la lentille focale variable selon l'invention de pouvoir fonctionner en microscope électronique à balayage, en testeur de circuit intégré ou en microsonde sans avoir à modifier l'espace $DT$ qui sépare la face avant de la lentille de l'échantillon à tester.

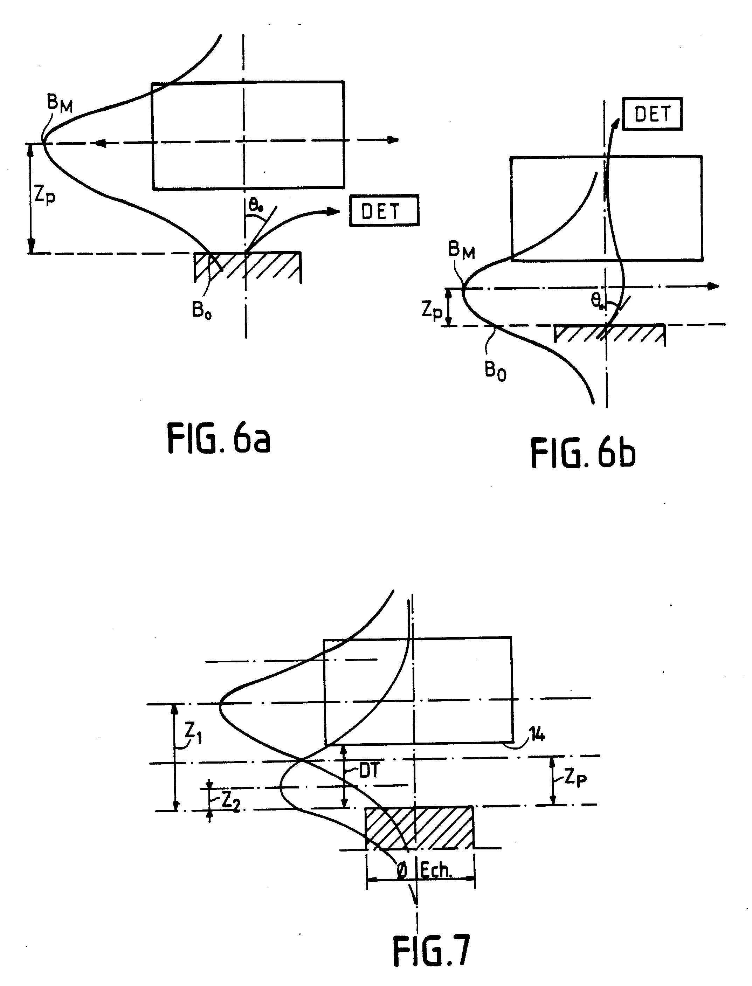

En effet, un fonctionnement mettant en valeur la disposition représentée par la figure 6a est obtenu facilement en plaçant le plan principal de la lentille loin de la surface de l'échantillon ; ce cas correspond à une forte valeur du rapport Bm/Bo entre le champ magnétique maximal et celui régnant au niveau de l'échantillon. Ce réglage produit une grande distance ZP permettant une grande surface de balayage ; et, il oblige aussi tout électron secondaire quittant la surface de l'échantillon sous un angle initial $\theta o$ (inclinaison par rapport à l'axe optique 1) à suivre une trajectoire s'écartant de plus en plus de l'axe optique avant de pénétrer dans un détecteur DET placé près de l'échantillon. Ce réglage correspond à une excitation de la bobine 2 très supérieure à celle de la bobine 3. Mais, un fonctionnement pour une disposition très différente est également possible : il s'agit du cas de la figure 6b où détecteur DET et échantillon sont de part et d'autre de la lentille. Le réglage correspondant est celui donnant un rapport Bm/Bo proche de l'unité, cette condition donne une faible distance Zp et limite l'inclinaison $\theta$ par confinement magnétique. Ainsi, les trajectoires des électrons traversant la lentille se rapprochent de l'axe optique 1 : un grand nombre d'électrons émis par l'échantillon sont dirigés le long de l'axe optique 1 pour atteindre le détecteur. Finalement, l'un et l'autre fonctionnement, ainsi que le fonctionnement intermédiaire correspondant à la figure 4 (0 entre les limites O1 et O2), sont tous utilisables dans les instruments fonctionnant avec l'un et/ou l'autre type de détecteur électronique : microscope électronique à balayage (MEB ou SEM), micro-analyseur électronique (EPMA) ou testeur de circuit intégré par sonde électronique.

La latitude de mise au point correspondante est schématisée à la figure 7. Le fait de pouvoir faire varier la distance ZP du plan principal par rapport à l'échantillon permet également d'obtenir des grandissements variables pouvant être très importants dans le mode de fonctionnement en microscope électronique à balayage sans qu'il soit nécessaire comme cela est réalisé pour les microscopes de l'art antérieur, de modifier la distance DT séparant l'échantillon de la face avant de la lentille. Egalement, la lentille selon l'invention permet des distances DT maximum très importantes, de quelques dizaines de mm par exemple, que les détections aient lieu au travers de la lentille ou entre la lentille et l'échantillon. D'autre part, comme les échantillons sont placés devant la pièce polaire avant 6, leur dimension n'est pas limitée par les dimensions physiques de la lentille et de ce fait il est possible de tester des échantillons de diamètres très importants.

## Revendications

1. Lentille électromagnétique composite à focale variable, caractérisé en ce qu'elle comprend une première lentille blindée (5, 6, 7, 8, 9) accolée à une deuxième lentille unipolaire (5, 6, 15), les deux lentilles étant traversées par un même canal central (10) s'étendant autour d'un axe optique (1) commun aux deux lentilles pour permettre le passage de particules électrisées à destination ou en provenance d'un objet ou échantillon à observer au travers de la première et de la deuxième lentille, chaque lentille étant munie d'une bobine d'induction (2, 3) pour déplacer la position ($Z_p$) sur l'axe optique de la lentille composite résultante en fonction du courant d'excitation des bobines d'induction (2, 3) des première et deuxième lentilles.

2. Lentille selon la revendication 1, caractérisée en ce que la distance de travail DT séparant l'objet ou de l'échantillon à observer de la deuxième lentille (5, 6, 15) reste à peu près fixe lorsque la distance focale varie.

3. Lentille selon les revendications 1 et 2 caractérisée en ce que les première et deuxième lentilles sont excitées par une première (2) et une deuxième (3) bobines d'induction montées sur un circuit magnétique commun (4).

4. Lentille selon l'une quelconque des revendications 1 à 3 caractérisée en ce que les première et deuxième lentilles ont des positions ($O_1$, $O_2$) sur l'axe optique (1) à l'endroit où leur champ d'induction est maximum et en ce que la distance ($O_1$, $O_2$) séparant la première de la deuxième lentille est égale ou inférieure à la valeur moyenne des largeurs à mi hauteur des courbes de champ axial ($B1(Z)$) et ($B2(Z)$), de façon que la courbe résultante ($B(Z)$) de la combinaison linéaire des champs axiaux ($B1(Z)$) et ($B2(Z)$) ne comporte pas de maximum secondaire.

5. Lentille selon la revendication 4 caractérisée en ce que le circuit magnétique de la première lentille comporte, montés à l'intérieur d'un corps à peu près cylindrique (5), une pièce polaire avant (6) et une pièce polaire arrière cylindrique (7) séparées par un entrefer annulaire (8).

6. Lentille selon la revendication 5 caractérisée en ce que la première bobine (2) est supportée par la pièce polaire arrière (7).

7. Lentille selon l'une quelconque des revendications 5 et 6 caractérisée en ce que le circuit magnétique de la deuxième lentille est formée par la pièce polaire avant (6), le deuxième entrefer (15), et l'extrémité du corps à peu près cylindrique (5) qui entoure la pièce polaire avant (7).

8. Lentille selon l'une quelconque des revendications 1 à 7 caractérisée en ce que la pièce polaire avant (6) à la forme d'un tronc de cône et comporte une embase (11) reposant sur un flanc de la première bobine (2) pour permettre l'éloignement de la première bobine (2) de l'entrefer annulaire (8) en permettant l'engagement à l'intérieur de la pièce avant (6) de l'extrémité de la pièce polaire arrière (7) à l'intérieur du tronc de cône.

9. Lentille selon l'une quelconque des revendications 1 à 8 caractérisée en ce que le deuxième entrefer (15) est délimité par les deux lèvres formées par la partie conique de la pièce polaire avant (6) et la partie du corps cylindrique (5) en vis à vis.

10. Utilisation de la lentille selon l'une quelconque des revendications 1 et 8 à la réalisation de l'objectif d'un microscope électronique à balayage.

11. Utilisation de la lentille selon l'une quelconque des revendications 1 à 8 à la réalisation de l'objectif d'un microscope électronique à balayage testeur de circuit intégré.

12. Utilisation de la lentille selon l'une quelconque des revendications 1 à 8 à la réalisation de l'objectif d'une microsonde électronique.

FIG.1

FIG.2

FIG.3

FIG.4

FIG.5

FIG. 6a

FIG. 6b

FIG.7

**Office européen des brevets**

Numero de la demande

EP 90 40 0714

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 410 356 (RUDOLF HELL GmbH)<br>* Page 1, lignes 10-25,39 - page 2, lignes 5,15-18,39 - page 3, ligne 3; page 5, lignes 1-7,31-37 *<br>--- | 1 | H 01 J 37/141<br>H 01 J 3/22 |
| A | US-A-4 419 581 (NAKAGAWA)<br>* Colonne 2, lignes 56-65; colonne 5, 3éme paragraphe; revendications; figure 2 *<br>----- | 1,3,5-7,9-11 | |

| | | | DOMAINES TECHNIQUES RECHERCHES (Int. Cl.5) |
|---|---|---|---|
| | | | H 01 J |

Le présent rapport a été établi pour toutes les revendications

| Lieu de la recherche | Date d'achèvement de la recherche | Examinateur |
|---|---|---|
| LA HAYE | 29-05-1990 | MARTIN Y VICENTE M.A. |